# EUROPEAN PATENT APPLICATION

(11) **EP 4 553 888 A1**
(43) Date of publication of application: **14.05.2025**
(21) Application number: 23208134.9
(22) Date of filing: 07.11.2023
(51) Int. Cl.: H01L 21/20

(54) **SURFACE PREPARATION METHOD FOR EPITAXIAL MATERIAL GROWTH**

(71) Applicant: AlixLabs AB, 22363 Lund (SE)
(72) Inventor: Karimi, Mohammad, 22474 Lund (SE); Suyatin, Dmitry, 22472 Lund (SE); Jafari Jam, Reza, 22487 Lund (SE); Sharma, Intu, 22468 Lund (SE); Danielsson, Oscar, 21429 Malmö (SE); Plamenova Ilarionova, Yoana, 22456 Lund (SE); Muhammad, Asif, 22274 Lund (SE); Valdemar Sundqvist, Jonas, 01328 Dresden (DE)
(74) Representative: Invent Horizon IP

(57) **Abstract**

A method of preparing a surface of a substrate and epitaxial material growth is disclosed. The method includes exposing the surface to a cyclic removal process to remove impurities and defects from the surface. This process involves modifying a top-most surface layer of the surface by introducing a chemical species, such as halogens, in a process chamber volume enclosing the substrate, to obtain a top-most modified surface layer of the surface. The method also includes evacuating excessive chemical species from the process chamber volume, activating the top-most modified surface layer to form volatile products, and optionally removing etch products from the process chamber volume. The cyclic removal process is followed by epitaxial material growth, wherein the growth material is different from the material of the surface.

## Description

### Field

The technology relates to the field of semiconductor manufacturing, specifically to the preparation of substrate surfaces and epitaxial material growth for improving the quality of thin films and interfaces in electronic devices. This field involves the development of methods and processes for cleaning, smoothing, and modifying substrate surfaces to enhance the performance and reliability of the resulting semiconductor devices.

### Background

Semiconductor devices and structures rely on the quality of materials grown on substrates, especially when it comes to dissimilar materials. The fabrication of high-quality films of III-Nitride materials on Si, such as GaN films on Si substrates, is of particular importance for improving the performance of these devices. The quality of the grown materials is often affected by defects and stress formed due to lattice mismatch between the substrate and the grown material. This lattice mismatch can cause strain and stress in the grown material, leading to defects and poor quality.

One approach to addressing this issue is to improve the surface preparation of the substrate before the material growth. Inadequate surface preparation can result in impurities and surface defects, which can negatively impact the quality of the grown material. Various methods have been proposed for surface preparation, including plasma etching and chemical mechanical polishing or planarization (CMP).

GB2601404A describes a method of preparing a silicon carbide wafer using a type of plasma etching with hydrogen bromide and oxygen to reduce surface roughness for subsequent epitaxial growth thereon. However, the disclosed plasma-based etching process often involve surface bombardment with energetic ions and irradiation with vacuum ultraviolet (VUV), which typically damage the surface and leave a damaged layer at the surface top. This can result in surfaces that are not completely damage-free. Additionally, this process does not address the problem of material growth on a dissimilar surface, which usually leads to strain formation.

Chemical mechanical polishing or planarization (CMP) is another common method for surface preparation. CMP is a process of smoothing surfaces with a combination of chemical and mechanical forces. However, the surface smoothening achieved by CMP is limited, and the topmost material surface layer is usually damaged due to the mechanical force involved. Furthermore, CMP is limited to macroscopic flat surfaces and cannot be applied to prepare patterned surfaces for material growth. Like plasma-based etching, CMP does not address the problem of material growth on a dissimilar surface, which usually leads to strain formation.

There is a need for improved methods of surface preparation that can reduce defects and stress in grown materials, particularly for dissimilar materials, to enhance the performance of semiconductor devices and structures. Such methods should ideally be capable of preparing both flat and patterned surfaces, minimizing damage to the surface, and addressing the issue of strain formation due to lattice mismatch between dissimilar materials.

### Summary

According to the first aspect of the disclosure, a method of preparing a surface of a substrate and epitaxial material growth is provided. The method includes exposing the surface to a cyclic removal process to remove impurities and defects from the surface. This process involves modifying a top-most surface layer of the surface by introducing a chemical species, such as halogens, in a process chamber volume enclosing the substrate, to obtain a top-most modified surface layer of the surface. The method also includes evacuating excessive chemical species from the process chamber volume, activating the top-most modified surface layer to form volatile products, and optionally removing etch products from the process chamber volume. The cyclic removal process is followed by epitaxial material growth, wherein the growth material is different from the material of the surface. This method provides a clean and smooth surface for the epitaxial material growth, resulting in high-quality films.

Optionally, in some examples, the modifying of the top-most surface layer is done in a gas phase that contains only neutral species. This can provide a more controlled and gentle modification process, reducing the risk of damage to the surface.

Optionally, in some examples, the cyclic removal process has an etch rate per cycle thereof, wherein the etch rate approaches zero as the number of cycles increases. This self-limiting feature ensures that the process does not over-etch the surface, preserving the desired surface properties.

Optionally, in some examples, the activation of the top-most modified surface layer is done in a gas phase that does not involve surface bombardment with ions. This can help to maintain a damage-free surface, which is crucial for the subsequent epitaxial material growth.

According to the second aspect of the disclosure, the method includes a step of a deposition process to overgrow impurities and defects on the surface, comprising modifying the top-most surface layer by introducing a chemical species in the process chamber volume for said overgrow. This additional step can help to further improve the surface quality and ensure a smooth and defect-free surface for the epitaxial material growth.

Optionally, in some examples, the step of the deposition process is preceding the cyclic removal process, or the step of the deposition process is succeeding the cyclic removal process. This flexibility in the order of the steps allows for optimization of the process depending on the specific substrate and growth material.

Optionally, in some examples, the chemical species for said overgrow comprises gallium, nitrogen, and optionally aluminum. These elements can be used to form a variety of compound semiconductor materials, such as III-nitride materials, which have numerous applications in optoelectronics and power electronics.

Optionally, in some examples, the deposition process is cyclic. This can provide a more controlled and uniform deposition process, ensuring a high-quality overgrowth layer.

Optionally, in some examples, the deposition process has a deposition rate per cycle thereof, wherein the deposition rate approaches zero as the number of cycles increases. This self-limiting feature ensures that the process does not over-deposit the material, preserving the desired surface properties.

Optionally, in some examples, at least one of the steps includes a self-limiting reaction that slows down or stops as a function of time or, equivalently, as a function of species dosage. This can help to ensure a controlled and precise process, avoiding over-etching or over-deposition of the material.

Optionally, in some examples, the self-limiting reaction comprises chemisorption, deposition, extraction, and/or conversion such as oxidation or nitridation. These types of reactions can provide a controlled and gentle process, reducing the risk of damage to the surface.

Optionally, in some examples, the method includes an additional passivation step preceding the epitaxial material growth to avoid surface oxidation or contamination prior to the material growth. This can help to further improve the surface quality and ensure a clean and defect-free surface for the epitaxial material growth.

Optionally, in some examples, the surface comprises a pattern, such as regularly arranged holes, lines, and/or pillars. This can provide additional control over the properties of the epitaxial material growth, such as strain relaxation and defect reduction.

Optionally, in some examples, the method includes retrieving process control information, such as information from optical emission and residual gas analysis, wherein process parameters of the method are adjusted based on the process control information. This can help to optimize the process in real-time, ensuring the best possible surface quality and epitaxial material growth.

According to the third aspect of the disclosure, a method for epitaxial material growth on a surface of a substrate is provided, comprising a cyclic process including a sequence of any of the steps according to the first aspect of the disclosure, followed by any of the steps according to the second aspect of the disclosure. The method includes repeating the sequence a plurality of times, epitaxial material growth of a growth material on the surface, and wherein the growth material is different from the material of the surface. This method can provide a highly controlled and optimized process for preparing the surface and growing high-quality epitaxial materials.

Optionally, in some examples, the steps are repeated until at least one of said steps has no further effect on the surface. This can help to ensure that the surface is fully prepared and optimized for the epitaxial material growth, resulting in high-quality films.

### Brief Description of the Drawings

Examples are described in more detail below with reference to the appended drawings. The figures should not be considered limiting; instead, they are used for explaining and understanding.
Figure 1 is a schematic illustrating the effect of a cyclic removal process for preparing substrate surfaces for improved material growth, comparing material growth on a typical surface and material growth after a cyclic removal process.
Figure 2 is a schematic illustrating the effect of a deposition process followed by a cyclic removal process for preparing substrate surfaces for improved material growth, comparing material growth on a typical surface and material growth after material deposition and the following cyclic removal process.
Figure 3 is a schematic illustrating the effect of a cyclic removal and deposition process for preparing substrate surfaces for improved material growth, comparing material growth on a typical surface and material growth after the cyclic removal and deposition process.
Figure 4 is a block diagram illustrating an execution process flow of a method of a cyclic process for preparing substrate surfaces for improved material growth.
Figure 5 shows Atomic force microscopy (AFM) micrographs and line scans of the initial Si surface and the surface after cyclic etching, demonstrating the reduction in roughness after the cyclic etch process.
Figure 6 shows Atomic force microscopy (AFM) micrographs of the initial GaN surface and the surface after cyclic deposition followed by cyclic etching, demonstrating the reduction in roughness after the cyclic deposition process followed by the cyclic etch process.

### Detailed Description

The detailed description set forth below provides information and examples of the disclosed technology with sufficient detail to enable those skilled in the art to practice the disclosure.

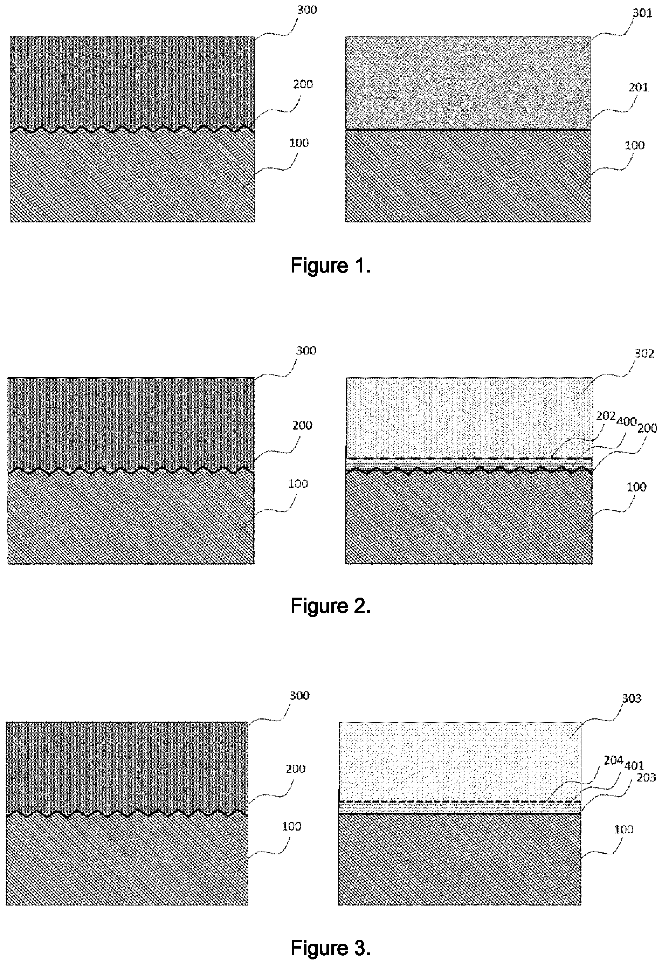

Figure 1 shows a schematic illustrating the effect of a cyclic removal process for preparing substrate surfaces (Si, Sapphire, SiC, GaN, or any substrates) for improved material growth. On the left side, material growth on a typical surface 200 of a substrate 100 is shown. On the right side, material growth after a cyclic removal process is shown, which results in a prepared substrate surface 201. The grown material 301 is improved by reducing defects compared to the grown material 300.

Figure 2 displays a schematic illustrating the effect of a deposition process followed by a cyclic removal process for preparing substrate surfaces (Si, Sapphire, SiC, GaN, or any substrates) for improved material growth. On the left side, material growth on a typical surface 200 of a substrate 100 is shown. On the right side, material growth after material deposition 400 and the following cyclic removal process is shown, resulting in a prepared substrate surface 202. The grown material 302 is improved by reducing defects compared to the grown material 300.

Figure 3 presents a schematic illustrating the effect of a cyclic removal and deposition process for preparing substrate surfaces (Si, Sapphire, SiC, GaN, or any substrates) for improved material growth. On the left side, material growth on a typical surface 200 of a substrate 100 is shown. On the right side, the cyclic removal and deposition process provides a substrate surface 204 for material growth. The intermediate flattened surface 203 of the substrate and the material deposition 401 are also shown. The grown material 303 is improved by reducing defects compared to the grown material 300.

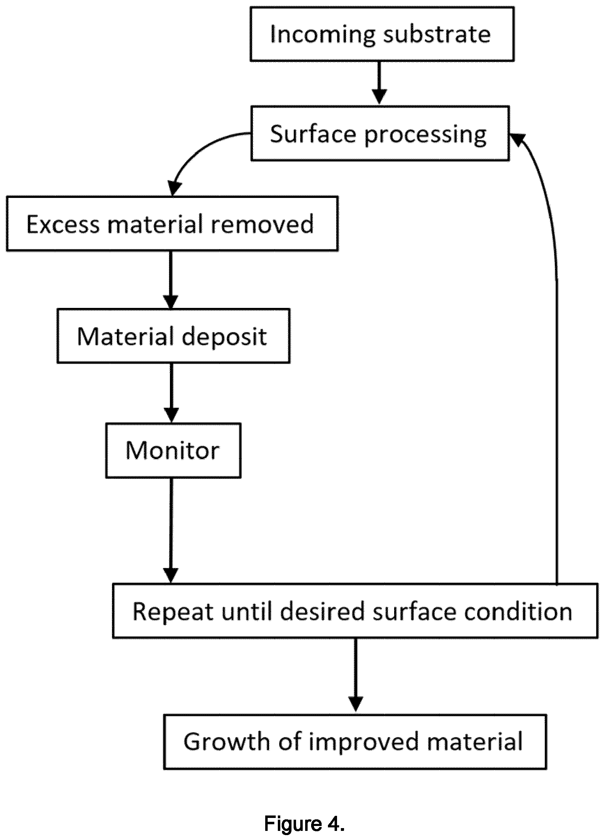

Figure 4 is a block diagram illustrating an execution process flow of a method of a cyclic process for preparing substrate surfaces for improved material growth.

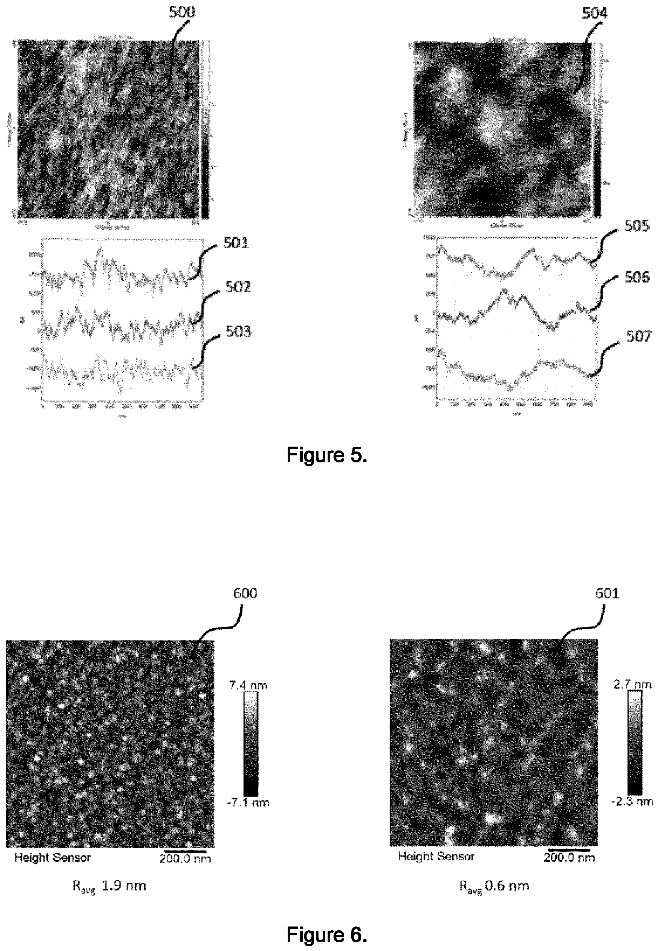

Figure 5 shows Atomic force microscopy (AFM) micrographs and line scans of the initial Si surface (Left) and the surface after cyclic etching (Right). The top parts, 500 and 504, display a micrograph of the scan area, where the area is 1 µm2. The bottom graphs 501, 502, 503, 505, 506, and 507 are line scans in different places of the corresponding scan areas 500 and 504: top, middle, and bottom, respectively. The roughness is substantially reduced after the cyclic etch process.

Figure 6 presents Atomic force microscopy (AFM) micrographs of the initial GaN surface (Left) and the surface after cyclic deposition followed by cyclic etching (Right). The roughness is substantially reduced after the cyclic deposition process followed by the cyclic etch process.

Further discussion of the surface preparation for epitaxial material growth in relation to figures 1 - 6 are provided below under sections 6 to 8.

### 2. Substrate material

In some examples, the material of the surface can be silicon (Si), sapphire, silicon carbide (SiC), gallium nitride (GaN), or any other suitable substrate material. The choice of the surface material can significantly impact the quality of the grown material and the effectiveness of the cyclic removal process. The surface may have various materials and patterns, which can affect the growth of the material. In some examples, the surface of the substrate may comprise a pattern, such as regularly arranged holes, lines, and/or pillars. The disclosed method can be applied to these patterned surfaces, allowing for the preparation of substrate surfaces with various geometries and topographies. The method may be adapted to accommodate various surface patterns to ensure optimal material growth.

### 3. Surface preparation method

### 3.1. Cyclic Removal Process

In one example, the cyclic removal process involves exposing the surface of a substrate to a series of steps that remove impurities and defects from the surface. This process can be repeated multiple times to achieve the desired surface quality.

### 3.1.1. Modifying the Top-Most Surface Layer

The top-most surface layer of the substrate is modified by introducing a chemical species, such as halogens, in a process chamber volume enclosing the substrate. The process chamber volume is an enclosed space where the substrate is exposed to the chemical species and the cyclic removal process takes place. The halogens may be chlorine, bromine, or iodine. The chemical species chemisorbs to the surface. This results in the formation of a top-most modified surface layer on the substrate. The modification step forms a thin reactive surface layer with a well-defined thickness that is subsequently more easily removed than the unmodified material. The modified layer is characterized by a sharp gradient in chemical composition. The speed of chemisorption can be increased by activating the chemical species, for example, with a plasma. The modifying of the top-most surface layer can be a self-limiting process, which slows down or stops as a function of time or, equivalently, as a function of species dosage.

In some examples, excessive chemical species may be evacuated from the process chamber volume after modifying the top-most surface layer. This evacuation can be done using an inert gas, ensuring that the process chamber volume is free from unwanted chemical species that may interfere with the cyclic removal process.

### 3.1.2. Activating the Top-Most Modified Surface Layer

The top-most modified surface layer is activated to form volatile products. The activation removes the thin reactive surface layer resulting from the previous surface modification step. This activation can be done in a gas phase that does not involve surface bombardment with ions, such as by temperature cycling, light pulse exposure, and/or chemical reactions. By excluding surface bombardment by energetic particles in the cyclic removal process, the formation of a damage-free surface can be ensured, providing an optimal surface for epitaxial material growth. The activation of the top-most modified surface layer can be a self-limiting process, which slows down or stops as a function of time or, equivalently, as a function of species dosage.

In some examples, the activation of the top-most modified surface layer may comprise a plasma pulse step, with low ion energies for the plasma pulse, such as ion energies below 60 eV. Ion energies around 20 eV provides in some examples a particularly advantageous result. The use of low ion energies ensures a low-damage etching of the surface, resulting in a damage-free surface that is optimal for epitaxial material growth.

In some examples, etch products may be removed from the process chamber volume after activating the top-most modified surface layer. This removal ensures that the process chamber volume is free from etch products that may interfere with the subsequent steps of the method, such as epitaxial material growth.

The surface modification and the activation steps provide an atomic layer etching process. The atomic layer etching process may further comprise quasi-atomic layer etching processes, which may include quasi-self-limiting reactions and non-self-limiting reactions. Isotropic atomic layer etching processes, which use thermal desorption and chemical reactions, are in some examples especially advantageous and provide optimized results for surface preparation before material growth.

The method of preparing a surface of a substrate and epitaxial material growth may comprise various optional features and steps, such as a deposition process to overgrow impurities and defects on the surface, a passivation step preceding the epitaxial material growth, and the use of self-limiting reactions in the cyclic removal process. These optional features can further enhance the effectiveness of the method and improve the quality of the grown material, and are described in more detail below.

### 3.1.3. Number of cycles and Etch Rate per Cycle

The number of cycles in the cyclic removal process can be optimized based on the roughness of the surface. The number of cycles is in the range of 5 to 200 cycles in one example. For instance, 20 cycles may provide a particularly optimal surface for material growth.

In some examples, the cyclic removal process has an etch rate per cycle, wherein the etch rate approaches zero as the number of cycles increases, indicating that the process becomes self-limiting as a function of time or species dosage. This allows for a facilitated process in controlling the amount of material removed from the surface, ensuring a smooth and defect-free surface for subsequent material growth.

The cyclic removal process can be combined with ion beam shaping processes to smoothen and clean different faces of structured surfaces, such as surfaces with patterns like regularly arranged holes, lines, and/or pillars. This can further enhance the quality of the grown material and expand the potential applications of the method.

### 3.2. Deposition Process

In some examples, the method may comprise a deposition process to overgrow impurities and defects on the surface. This process involves modifying the top-most surface layer by introducing a chemical species in the process chamber volume for the overgrow. The chemical species for the overgrow can comprise gallium, nitrogen, and optionally aluminum. The deposition process may comprise quasi-atomic layer deposition processes, which may include quasi-self-limiting reactions and non-self-limiting reactions.

### 3.2.1. Overgrowing Impurities and Defects

In some examples, the deposition process provides an interface layer by depositing a thin film material on the surface. This interface layer can relax the strain caused by lattice mismatch of dissimilar materials in contact with each other, alleviating the lattice mismatch problem with the material subsequently grown by epitaxy. The deposition process can also fill valleys on the surface, ensuring that the surface remains smooth even during the subsequent epitaxial growth of very thin films.

The deposition process may precede or succeed the cyclic removal process, depending on the desired surface quality and material growth requirements. In some cases, an additional passivation step may be performed before the epitaxial material growth to avoid surface oxidation or contamination prior to the material growth. This can further improve the quality of the grown material.

### 3.2.2. Chemical Species for Overgrow

In some examples, the chemical species for the overgrow can comprise gallium, nitrogen, and optionally aluminum. The deposition process can involve forming a monolayer of gallium atoms, followed by forming an atomic layer of gallium nitride on the surface.

### 3.2.3. Cyclic Deposition Process

In some examples, the deposition process can be cyclic, with the deposition rate approaching zero as the number of cycles increases. This allows for a facilitated control over the thickness of the deposited material and ensures a smooth and defect-free surface for subsequent material growth. The deposition process can be a self-limiting process as a function of time or species dosage, as described in further detail below.

The number of cycles in the deposition process can be optimized based on the roughness of the surface. The number of cycles is in the range of 5 to 200 cycles in one example. For instance, 20 cycles may provide a particularly optimal surface for material growth.

### 4. Cyclic Process and subsequent Epitaxial Material Growth

In some examples, the method may involve a sequence of steps in the cyclic process, including any of the steps described in sections 3.1 and 3.2. The total sequence can be repeated a plurality of times to achieve an optimized surface quality and prepare the surface for epitaxial material growth. The growth of high-quality films of various materials on the prepared substrate surface is provided.

In some examples, the total sequence of steps in the cyclic process may be repeated a plurality of times to achieve an optimized surface quality. The number of cycles can be optimized based on the roughness of the surface, with a range of 5 to 200 cycles being possible. For instance, 20 cycles may provide a particularly optimal surface for material growth.

Thus, following the cyclic process, epitaxial material growth is performed on the prepared surface of the substrate. This involves forming a high-quality film of the growth material on the substrate surface. The growth material is different from the material of the surface, and in some examples, it may be a III-Nitride material grown on a silicon substrate.

The cyclic process can be integrated with growth techniques, such as molecular beam epitaxy (MBE) or metal-organic chemical vapor deposition (MOCVD), providing the surface preparation in the same chamber, alternatively, in a neighboring chamber without exposure to ambient air in between the surface preparation and the growth process, which additionally improves the quality of the grown films. The method can also be combined with other processes such as atomic layer cleaning, rapid surface temperature cycling, and self-organization, to further enhance the quality of the grown material.

The method may comprise retrieving process control information, such as information from optical emission and residual gas analysis, and adjusting process parameters of the method based on the process control information. This can help optimize the process for different substrates and surface patterns, resulting in improved material growth. I.e. monitoring and control of the cyclic process are used to adjust the process parameters as required for the desired outcome. In situ control is preferred and typically includes monitoring of such parameters as optical emission, residual gas analysis, and monitoring thin film properties in various ways, for instance, with light interferometry. By monitoring these parameters, the process endpoint and intermediate process points can be determined, and the process time and process parameters adjusted as necessary to achieve the improved and prepared surface for material growth.

### 5. Self-Limiting Reactions

In some examples, the method may comprise at least one self-limiting reaction that slows down or stops as a function of time or, equivalently, as a function of species dosage. These self-limiting reactions can provide a controlled and precise process for modifying the surface layer and activating the top-most modified surface layer, as well as providing a controlled and precise deposition process in some examples, ensuring a consistent and high-quality surface preparation for epitaxial material growth.

Processes in the prior art, such as in GB2601404A, does not stop after the removal of the uneven damaged surface layers and will etch underlying originally damage-free layers. This may be a big disadvantage for smoothening very thin films and structures for which the removal of a few additional nanometers of material may be critical and unwanted. Chemical mechanical polishing or planarization (CMP) processes also do not stop after the removal of the uneven damaged surface layers and will remove some underlying originally damage-free layers.

In one example, the self-limiting reaction may comprise chemisorption, where a chemical species chemisorbs to the surface. In some examples, the self-limiting reaction may comprise deposition, where a chemical species is introduced to the process chamber volume for overgrowing impurities and defects on the surface. In one example, the self-limiting reaction may comprise extraction. In the extraction case, the original material is a compound of elements, and the surface modification step removes one element preferentially from the surface, while a different element is removed in the subsequent activation/removal step. This extraction process can be self-limiting, slowing down or stopping as a function of time or species dosage. The controlled extraction process can provide a consistent and damage-free removal of the top-most modified surface layer, providing a clean and smooth surface for epitaxial material growth. In some examples, the self-limiting reaction may comprise conversion, such as oxidation or nitridation, where the chemical species introduced to the process chamber volume reacts with the surface to form a modified surface layer. This conversion process can be self-limiting, slowing down or stopping as a function of time or species dosage. The controlled conversion process can provide a consistent and precise modification of the surface layer, providing an optimal surface for epitaxial material growth.

### 6. Examples of process steps in different orders

In this section, various examples of the disclosed method for preparing substrate surfaces for improved material growth are described. These examples illustrate different configurations and sequences of the method steps, which can be tailored to specific applications and requirements.

### 6.1. Deposition Process Preceding Cyclic Removal Process

In one example, the deposition process precedes the cyclic removal process. This configuration can be advantageous in certain situations, as it allows for the formation of an interface layer by depositing a thin film material on the substrate surface before the cyclic removal process. The interface layer can help relax the strain caused by lattice mismatch between dissimilar materials in contact with each other, alleviating the lattice mismatch problem with the material subsequently grown by epitaxy. This embodiment is illustrated in Figure 2, where the material deposition 400 is followed by the cyclic removal process, resulting in a prepared substrate surface 202.

### 6.2. Deposition Process Succeeding Cyclic Removal Process

In another example, the deposition process succeeds the cyclic removal process. This configuration can be advantageous in certain situations, as it allows for the overgrowth of impurities and defects on the surface after the cyclic removal process. The deposition process can fill the valleys on the surface, ensuring that the surface remains smooth even during the subsequent epitaxial growth of very thin films. This embodiment is illustrated in Figure 3, where the cyclic removal process is followed by the material deposition 401, resulting in a prepared substrate surface 204.

### 6.3. Passivation Step Preceding Epitaxial Material Growth

In some examples, the method may comprise an additional passivation step preceding the epitaxial material growth. This can further enhance the quality of the grown material by protecting the prepared surface from unwanted reactions with ambient gases or contaminants. E.g. the passivation step can be advantageous in avoiding surface oxidation or contamination prior to the material growth, ensuring a high-quality film of the growth material on the prepared substrate surface. The passivation step can be performed using various techniques, such as chemical passivation, plasma passivation, or thermal passivation.

### 7. Examples of surface preparation for epitaxial material growth

### 7.1 The first example process relates to Figure 1 and 4:

The surface of Si is smoothened with the cyclic removal process, and then a GaN material is grown on top of this surface.

### Process Steps:

1. Preclean: Before starting the cyclic process, it is preferred that the silicon substrate is free of contaminants and native oxides. This can be achieved through a pre-clean step, often involving a brief exposure to a plasma or chemical treatment to remove impurities. Buffered oxide etch (BOE) 10:1 for the native oxide removal on Si surface is advantageous, and can be performed by immersing the substrate into a buffered HF for 30 s, followed by 30 s of rinsing in deionized water and dry blow with N2 for 15 s.
2. Initial gas exposure for modifying a top-most surface layer of the surface: In the cyclic removal process, first, the Si surface is exposed to chlorine gas, which chemisorbs on the surface. This step is self-limiting and slows down or stops as a function of time or, equivalently, as a function of species dosage. For faster chemisorption, it may be advantageous to activate Cl2 gas with, e.g. plasma. Example process parameters for this step:
   - Chlorine (Cl2) Flow: Ranging from 1 to 40 sccm (standard cubic centimeters per minute).
   - Pressure: between 1 mTorr (millitorr) and 60 mTorr, and set to 3 mTorr in a preferred example.
   - Time: between 15 milliseconds to 2 minutes. For inactivated Cl2 gas at room temperature, a preferred time is between 5 s and 60 s and is determined based on the process pressure. For 20 mTorr process pressure at room temperature, an optimal exposure time was determined to be 20 s. Specific optimal parameters may depend on other process details, such as the gas flow. The optimal gas flow is determined based on the process chamber volume and the exposed sample surface. In an example a Cl2 gas flow above 20 sccm was determined to be optimal for the process results. It was determined that there is no spontaneous Si etching with Cl2 gas at room temperature if the gas is not activated.
3. Purge - evacuating excessive chemical species: After the surface chlorine chemisorption, the reactor is purged with an inert gas (such as argon) to remove any excess chlorine gas from the chamber volume. Example process parameters for this step:
   - Argon (Ar) Flow: between 3 and 80 sccm.
   - Purge Time: between 15 ms and 120 seconds, and set to 40 seconds in a preferred example.
   - Pressure: Maintained between 1 and 60 mTorr, and set to 3 mTorr in a preferred example.
4. Activating the top-most modified surface layer to form volatile products, in this example using a plasma pulse step. During this step, a plasma is generated using an inert gas (such as argon (Ar) gas). Ions from the plasma are used to remove the topmost activated layer by the chlorine chemisorption. Example process parameters for this step:
   - Argon (Ar) Flow: Controlled from 1 to 40 sccm, and set to 20 sccm in a preferred example.
   - Ion Energies: below 60 eV. Ion energies around 20 eV was determined to provide the best results.
   - Time: between 3 seconds and 60 seconds, and set to 10 seconds in a preferred example.
   - Pressure: between 1 mTorr and 60 mTorr, and set to 3 mTorr in a preferred example.
5. Optional second purge step - removing etch products: Its primary purpose is to remove any remaining etchant gases, reaction byproducts, or other contaminants from the reaction chamber before proceeding with the next cycle of the cyclic removal process. Example process parameters for this step:
   - Argon (Ar) Flow: Between 3 and 80 sccm. A flow at 20 sccm was determined to provide the best results.
   - Purge Time: between 2 and 20 seconds. A purge time of 2 seconds was determined to provide the best results.
   - Pressure: Maintained between 1 and 60 mTorr. A pressure at 3 mTorr was determined to provide the best results.
6. Repeat Cycles:
   Steps 2 through 5 are repeated for a specific number of cycles. An advantageous number of repetitions was determined to be between 5 to 200 repetitions, and is determined based on the original roughness of the Si surface. For a typical Si surface after a chemical-mechanical polishing (CMP) process, the optimal number of cycles was determined to be 20 cycles.

These precise parameters were particularly advantageous to smoothen the Si surface to the extent needed to grow improved GaN material on top of this surface, see Figure 5.

### 7.2. The second example process relates to Figure 3 and 4:

In this example, the process outlined in the first example is followed by a deposition process to overgrow impurities and defects on the surface. Particularly advantageous results are achieved when the deposition process is done in the same chamber as the cyclic removal process presented in the first example. This allows minimizing the top surface oxidation after previous processing.

### Process Steps:

1. Purge: This step removes excess gases. Example process parameters for this step:
   - Inert Gas Purge: Argon (Ar), set to 20 sccm in a preferred example.
   - Purge Time: between 30-60 s, set to 30 s in a preferred example.
   - Purge Pressure: between 1-10 mTorr. A pressure at 10 mTorr was determined to provide the best results.
2. Deposition process - Gallium (Ga) Precursor pulse: Introduce a controlled pulse of trimethylgallium (TMG) into the reaction chamber. TMG reacts with the GaN surface to form a monolayer of gallium atoms. Example process parameters for this step:
   - TMG Flow Rate: between 10-50 sccm, was set to 20 sccm in a preferred example.
   - Pulse Time: between 0.1-2 seconds, was set to 1 s in a preferred example.
   - Chamber Pressure: between 1-100 mTorr, was set to 50 mTorr in a preferred example.
   - TMG Vaporizer Temperature: between 60-100°C, was set to 80°C in a preferred example.
3. Purge - Inert Gas: to remove excess TMG and reaction byproducts from the previous step, ensuring that only one monolayer of gallium atoms remains on the substrate surface. Example process parameters for this step:
   - Ar Flow Rate: between 50-200 sccm, was set to 100 sccm in a preferred example.
   - Purge Time: between 10-30 seconds, was set to 20 s in a preferred example.
   - Purge Pressure: between 1-10 mTorr, was set to 10 mTorr in a preferred example.
4. Deposition process - Nitrogen (N) Precursor pulse: Ammonia (NH3) is introduced to react with the exposed gallium atoms on the surface, forming a monolayer of GaN. This completes the deposition of one atomic layer of GaN. Example process parameters for this step:
   - H3 Flow Rate: between 10-50 sccm, was set to 20 sccm in a preferred example.
   - Pulse Time: between 0.1-2 seconds, was set to 1 s in a preferred example.
   - ALD Chamber Pressure: between 1-100 mTorr. A pressure at 50 mTorr was determined to provide the best results.
5. Purge - Inert Gas: Similar to the previous purge step, argon gas is used to remove excess NH3 and reaction byproducts to prepare the surface for the next cycle. Example process parameters for this step:
   - Ar Flow Rate: between 50-200 sccm
   - Purge Time: between 10-30 seconds
   - Purge Pressure: between 1-10 mTorr
6. Repeat Cycles: Steps 2 through 5 are repeated for a specific number of cycles. An advantageous number of repetitions was determined to be between 5 to 200 repetitions. The optimal number of cycles was determined to be 20 cycles, to build up the initial nucleation layer of GaN.

The process is preferably continuously monitored, and the process parameter data is analyzed. Such in situ characterization techniques as, for example, optical emission spectroscopy (OES) and optical reflectometry, can be used for this process monitoring. The preferred way for this process monitoring is by verifying the actual process parameters and comparing them to reference values. Specifically, it was found to be the best to monitor the process by in-line tracking radio frequency (RF) signal applied and reflected to maintain the plasma and the corresponding matching parameters for the RF line. This monitoring allows precise adjustment of the number of cycles needed to prepare the surface for subsequent GaN material growth on top. Depending on the process monitoring results, it may be advantageous to repeat the process steps outlined in the first example. In some cases, the plasma pulse step (step 3) needs to be adjusted, typically by increasing the ion energy by keeping it below 90 eV. Ion energy around 30 eV were in some examples determined to provide the best results. In some examples, the steps in of the above first and second examples may need to be repeated a number of times. A repetition of 5 times was determined to provide the optimal results. The number of these repetitions can be optimized and determined based on situ monitoring and process tracking.

### 8. Experimental Results

This section provides a detailed description of the experimental results obtained using the disclosed method for preparing substrate surfaces for improved material growth. The results demonstrate the effectiveness of the method in reducing surface roughness and improving the quality of the grown material.

### 8.1. Atomic Force Microscopy (AFM) Micrographs

In one example, Atomic Force Microscopy (AFM) micrographs were used to analyze the surface roughness of the substrate before and after the cyclic removal process.

The AFM micrographs provide a visual representation of the surface topography, allowing for a direct comparison of the surface roughness before and after the process. The reduction in surface roughness observed in the AFM micrographs was also quantitatively analyzed to demonstrate the effectiveness of the method.

### 8.1.1. Initial Si Surface and Surface after Cyclic Etching

In one example, the initial Si surface (Figure 5, left) was compared to the surface after a cyclic removal process, i.e. cyclic etching (Figure 5, right). The AFM micrographs show a significant reduction in surface roughness after the cyclic removal process. The top parts of the micrographs, 500 and 504, display a scan area of 1 µm2. The bottom graphs 501, 502, 503, 505, 506, and 507 are line scans in different places of the corresponding scan areas 500 and 504: top, middle, and bottom, respectively. The reduction in surface roughness after the cyclic removal process demonstrates the effectiveness of the method in preparing the substrate surface for improved material growth.

### 8.1.2. Initial GaN Surface and Surface after Cyclic Deposition and Etching

In another example, the initial GaN surface (Figure 6, left) was compared to the surface after cyclic deposition followed by a cyclic removal process, i.e. cyclic etching (Figure 6, right). The AFM micrographs show a substantial reduction in surface roughness after the combined cyclic deposition and removal process. This result demonstrates that the optional deposition process may further enhance the surface preparation for improved material growth.

The reduction in surface roughness observed in these examples demonstrates the advantages of the disclosed method in preparing substrate surfaces for improved material growth. By reducing surface roughness, the method may significantly reduce the number of defects in the material grown on the surface, resulting in higher-quality films. Additionally, the method may be combined with ion beam shaping processes to further enhance the surface preparation and improve material growth on various substrates.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A method of preparing a surface of a substrate and epitaxial material growth, the method comprising the steps of:
exposing the surface to a cyclic removal process to remove impurities and defects from the surface comprising:
modifying a top-most surface layer of the surface by introducing a chemical species, such as halogens, in a process chamber volume enclosing the substrate, to obtain a top-most modified surface layer of the surface,
evacuating excessive chemical species from the process chamber volume,
activating the top-most modified surface layer to form volatile products,
optionally removing etch products from the process chamber volume, wherein the cyclic removal process is followed by epitaxial material growth, and wherein the growth material is different from the material of the surface.

2. Method according to claim 1, wherein the modifying of the top-most surface layer is done in a gas phase that contains only neutral species.

3. Method according to any of the previous claims 1 - 2, wherein the cyclic removal process has an etch rate per cycle thereof, wherein the etch rate approaches zero as the number of cycles increases.

4. Method according to any of the previous claims 1 - 3, wherein the activation of the top-most modified surface layer is done in a gas phase that does not involve surface bombardment with ions.

5. Method according to any of the previous claims 1 - 4, comprising a step of a deposition process to overgrow impurities and defects on the surface comprising modifying the top-most surface layer by introducing a chemical species in the process chamber volume for said overgrow.

6. Method according to claim 5, wherein the chemical species for said overgrow comprises gallium, nitrogen, and optionally aluminum.

7. Method according to claim 5 or 6, where the deposition process is cyclic.

8. The method, according to any of the previous claims 5-7, wherein the deposition process has a deposition rate per cycle thereof, wherein the deposition rate approaches zero as the number of cycles increases.

9. Method according to any of the previous claims 1 - 8, wherein at least one of the steps includes a self-limiting reaction that slows down or stops as a function of time or, equivalently, as a function of species dosage.

10. Method according to claim 9, wherein the self-limiting reaction comprises chemisorption, deposition, extraction, and/or conversion such as oxidation or nitridation.

11. Method according to any of the previous claims 1 - 10, comprising an additional passivation step preceding the epitaxial material growth to avoid surface oxidation or contamination prior to the material growth.

12. Method according to any of the previous claims 1 - 11, wherein the surface comprises a pattern, such as regularly arranged holes, lines, and/or pillars.

13. Method according to any of the previous claims 1 - 12, comprising retrieving process control information, such as information from optical emission and residual gas analysis, wherein process parameters of the method are adjusted based on the process control information.

14. A method for epitaxial material growth on a surface of a substrate, comprising a cyclic process comprising a sequence of
any of the steps according to any of claims 1 - 4 followed by any of the steps according to any of claims 5 - 11, the method comprising
repeating the sequence a plurality of times,
epitaxial material growth of a growth material on the surface, and
wherein the growth material is different from the material of the surface.

15. The method, according to claim 14, where the steps are repeated until at least one of said steps has no further effect on the surface.
